**Europäisches Patentamt**

**European Patent Office**

**Office européen des brevets**

(11) Veröffentlichungsnummer: **0 073 452**
**A1**

# (12) EUROPÄISCHE PATENTANMELDUNG

(21) Anmeldenummer: **82107738.5**

(22) Anmeldetag: **24.08.82**

(51) Int. Cl.³: **G 01 R 13/40**

(30) Priorität: **28.08.81 DE 3134154**

(43) Veröffentlichungstag der Anmeldung: **09.03.83**
Patentblatt **83/10**

(84) Benannte Vertragsstaaten: **AT CH GB IT LI NL**

(71) Anmelder: **METRAWATT GMBH NÜRNBERG,**
**Thomas-Mann-Strasse 20, D-8500 Nürnberg (DE)**

(72) Erfinder: **Grotter, Friedrich, Berletzhausen 4,**
**D-8079 Kinding (DE)**
Erfinder: **Haussel, Werner, Dipl.-Ing. (FH),**
**Frühlingsstrasse 75, D-8501 Feucht (DE)**

(74) Vertreter: **Kempe, Wolfgang, Dr. et al, c/o Brown, Boveri**
**& Cie AG Postfach 351, D-6800 Mannheim 1 (DE)**

(54) **Anzeigevorrichtung mit reihenförmig angeordneten ansteuerbaren Anzeigeelementen.**

㉗ Die Erfindung betrifft eine Anzeigevorrichtung mit reihenförmig angeordneten ansteuerbaren Anzeigeelementen, wobei die Anzeigeelemente einerseits zu Gruppen zusammengefaßt sind sowie andererseits ranggleiche Elemente in den einzelnen Gruppen zusammengeschaltet sind und in kurzzeitigem für das Auge des Betrachters unerkennbarem Wechsel entweder die EIN-Gruppen, in denen alle Anzeigeelemente zu erregen sind, oder die gemischte Gruppe, in der nur ein Teil der Anzeigeelemente zu erregen ist, angesteuert werden. Die als Binärworte vorliegenden Meßwerte und Grenzwerte werden Byte-seriell in Speichern (1a, b, c, d) abgespeichert. Während eines Anzeigezyklus werden sukzessive sowohl der Meßwert als auch die Grenzwerte (oberer, unterer Grenzwert, Mittelwert) angezeigt. Hierzu sind den Speichern (1a, b, c, d) einzeln steuerbare Schalter (3a, b, c, d) nachgeschaltet und die Anzeigewerte werden in eine Zählerkette (7, 8, 9) eingelesen. Über einen Speicher (10), eine Ansteuerlogik (11) und eine Ansteuersignaldurchschaltung (12) gelangen die Werte zur Anzeige in eine Doppelband-Flüssigkristall-Bargraph-Anzeige (14a, b) zur Balkendarstellung für den Meßwert und Markendarstellung für die Grenzwerte. Für eine Doppelband-Flüssigkristall-Bargraph-Anzeige sind zwei der beschriebenen Bargraph-Treiber erforderlich.

0073452

M E T R A W A T T G.m.b.H.

Nürnberg                                    25. Aug. 1981
Mp.-Nr. 622/81                              ZPT/P3-Pn/Bt

Anzeigevorrichtung mit reihenförmig angeordneten ansteuerbaren Anzeigeelementen.

Die Erfindung bezieht sich auf eine Anzeigevorrichtung mit
reihenförmig angeordneten ansteuerbaren Anzeigeelementen
gemäß dem Oberbegriff des Anspruchs 1.

Eine solche Anzeigevorrichtung mit reihenförmig angeordneten
ansteuerbaren Anzeigeelementen ist aus der DE-OS 24 08 062
bekannt. Bei dieser Anzeigevorrichtung werden Schieberegister
als Zählerstufen mit nachgeschalteten Speichern verwendet und
als Steuerteil dient eine Flip/Flop-Anordnung. Es werden
lediglich Meßwerte dargestellt. Eine Darstellung von Grenzwerten als Marken ist in nachteiliger Weise nicht vorgesehen.

Aus der DE-OS 27 40 858 ist ein Verfahren zur Balkenschreiber-Anzeige von Meßwerten bekannt, bei dem während des
Tastintervalls, in dem die EIN-Gruppen angesteuert werden,
die Amplitude des Anwahlsignales für die Anzeigeelemente in
der gemischten Gruppe gleich Null ist. Dadurch wird das Spannungs-Diskriminations-Verhältnis zwischen angewählten und nicht angewählten Anzeigeelementen und somit der Kontrast bei der Anzeige erheblich verbessert. Desweiteren ist vorgesehen, mehrere Bargraph-Anzeigen zu einer einzigen Matrix zusammenzuschalten, wobei alle EIN-Gruppen in gleicher Weise und auch alle AUS-Gruppen in gleicher Weise adressiert und die verschiedenen gemischten Gruppen im Multiplex angesteuert werden.

Der Erfindung liegt die Aufgabe zugrunde, bei einer Anzeigevorrichtung mit reihenförmig angeordneten ansteuerbaren Anzeigeelementen eine einfache Ansteuerung der Bargraph-Anzeigen sowohl als geschlossenen Balken zur Meßwertdarstellung als auch als Marke zur Darstellung für Grenzwerte zu ermöglichen.

Diese Aufgabe wird durch die im Anspruch 1 gekennzeichneten Merkmale gelöst.

Die mit der Erfindung erzielbaren Vorteile liegen insbesondere darin, daß durch die für das Auge des Betrachters gleichzeitige Anzeige von Meßwerten und zugehörigen Grenzwerten bzw. Sollwerten ein sofortiger Soll/Istwert-Vergleich durchführbar ist. Das Spannungs-Diskriminations-Verhältnis ist dabei vorteilhaft hoch. Ferner kann die erfindungsgemäße Anzeigevorrichtung als Grenzwertsignalgeber, als quasianaloge Anzeige in Multimetern, als Füllstandsanzeige usw. mit Erfolg eingesetzt werden.

Vorteilhafte Ausgestaltungen der Erfindung sind in den Unteransprüchen gekennzeichnet.

Die Erfindung wird nachfolgend anhand der in den Zeichnungen

0073452

dargestellten Ausführungsformen erläutert.

Es zeigen:

Fig. 1        ein Blockschaltbild des Ansteuerbausteines für
              Flüssigkristall-Bargraph-Anzeigen,

Fig. 2        die Ansteuersignale zur Darstellung von
              Meßwerten und Grenzwerten,

Fig. 3        ein Beispiel für eine Grenzwertdarstellung
              (Markendarstellung),

Fig. 4        eine Meßwertvorgabe mittels Analog/Digital-Wandler,

Fig. 5        eine Grenzwertvorgabe mittels Tastatur,

Fig. 6        eine Meßwertvorgabe mittels Spannungs/Frequenz-Wandler,

Fig. 7        eine gleichzeitige Meßwert- und Grenzwertvorgabe,

Fig. 8a, b, c verschiedene Meßwert- und Grenzwertdarstellungen.

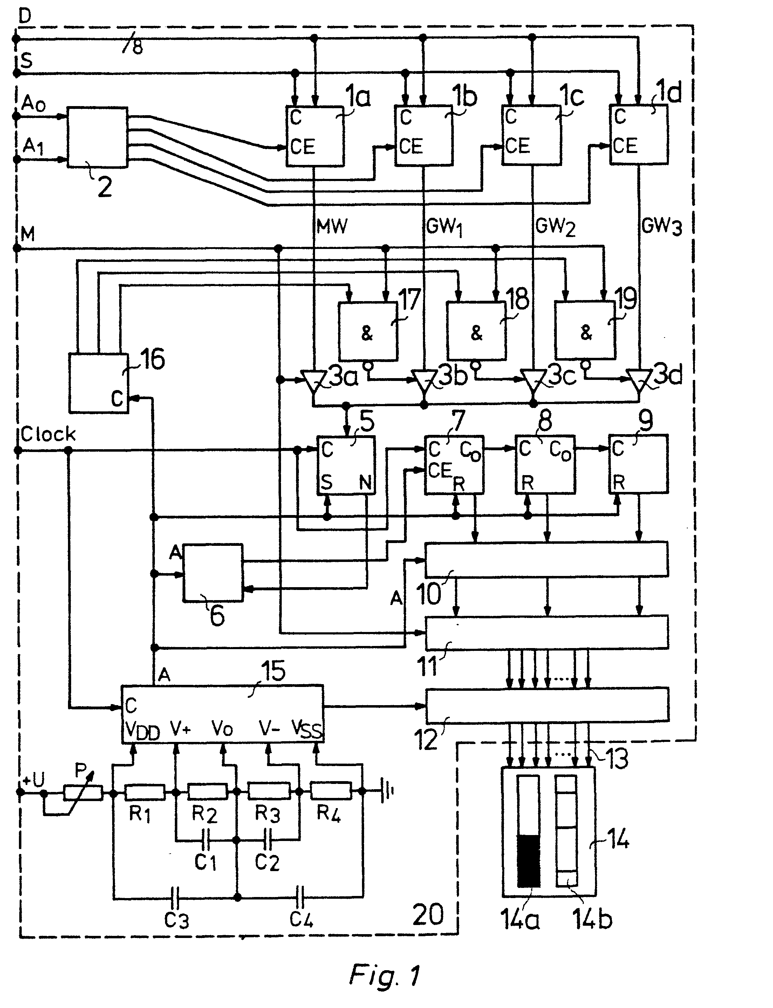

In Fig. 1 ist ein Blockschaltbild des Ansteuerbausteines für
Flüssigkristall-Bargraph-Anzeigen dargestellt. Die Anzeigen
dienen zur quasianalogen Darstellung von digital erfaßten
Meßwerten als Balken (Bargraph) und von digital erfaßten
Grenzwerten (im Ausführungsbeispiel 3 Grenzwerte) als Marken.
Dabei ist eine Doppelbandanzeige zu je 100 Segmenten vorgesehen. Ein Band soll als Meßwertanzeige arbeiten, das andere
Band als Grenzwertanzeige. Jedes Band besteht aus 10 Gruppen
zu je 10 Anzeigeelementen.

Über den Dateneingang D werden die digital vorliegenden
Meßwerte bzw. Grenzwerte dem Ansteuerbaustein zugeführt. Im
Ausführungsbeispiel besteht diese Eingangsinformation aus
7-Bit-Binärworten $2^6$, $2^5$, $2^4$, $2^3$, $2^2$, $2^1$, $2^0$ und wird Bit-pa-

rallel, jedoch Byte-seriell vier parallel angeordneten Speichern 1a, 1b, 1c, 1d eingegeben. Die Speicher 1a,b,c,d empfangen jeweils über ihren C-Eingang Strobe-Taktimpulse S zur Übernahme der Eingangsinformation D in die Speicher 1a bis d. Dem Ansteuerbaustein liegen ferner digitale Adreß-Eingangssignale $A_0$, $A_1$ an, die mittels eines Adreßdecoders 2 decodierbar sind. Der Adreßdecoder 2 liefert seinerseits Signale an die CE-Eingänge (Chip Enable) der Speicher 1a,b,c,d.

Durch die jedem Byte angelegte 2-Bit-Adresse $A_0$, $A_1$ wird sichergestellt, daß die über den Dateneingang D parallel an jedem Speicher 1a,b,c,d anstehende Eingangsinformation nur in den dafür vorgesehenen Speicher abgespeichert wird. So wird z.B. im Speicher 1a der Meßwert MW (1. Byte), im Speicher 1b der untere Grenzwert $GW_1$ (2. Byte), im Speicher 1c der Mittelwert $GW_2$ (3. Byte) und im Speicher 1d der obere Grenzwert $GW_3$ (4. Byte) abgespeichert. Die Werte MW, $GW_1$, $GW_2$, $GW_3$ werden sukzessive über den Dateneingang D eingegeben und die richtige Einspeicherung erfolgt mittels der Adreßsignale $A_0$, $A_1$.

Die Ausgangssignale MW, $GW_1$, $GW_2$, $GW_3$ der Speicher 1a,b,c,d werden über steuerbare Schalter 3a, 3b, 3c, 3d einem gemeinsamen Datenbus 4 zugeführt. An den Datenbus 4 ist ein voreinstellbarer binärer Rückwärtszähler 5 (z.B. 8-Bit-Rückwärtszähler) angeschlossen.

Der Rückwärtszähler 5 wird durch das Ausgangssignal des Datenbus 4 auf einen entsprechenden Wert voreingestellt. Bei Vorliegen eines Signales an seinem Setzeingang S zählt der Rückwärtszähler 5 vom voreingestellten Wert abwärts bis zum Wert Null im Takt der ihm über seinen C-Eingang zugeführten Clock-Taktimpulse (Frequenz etwa 80 kHz). Bei Vorliegen des Wertes Null gibt der Rückwärtszähler 5 ein Nullanzeigesignal N an eine Zählersteuerung 6 ab.

Die Ausgangsimpulse der Zählersteuerung 6 werden dem CE-Eingang eines ersten BCD-Zählers 7 zugeleitet. Der C-Eingang dieses Zählers 7 wird ebenfalls mit Clock-Impulsen beaufschlagt. Der Ausgang $C_0 = C_{out}$ des Zählers 7 ist mit dem C-Eingang eines zweiten BCD-Zählers 8 verbunden. An den Ausgang $C_0 = C_{out}$ des Zählers 8 ist der C-Eingang eines dritten BCD-Zählers 9 angeschlossen.

Der Zähler 7 zählt nach Vorliegen eines Signales an seinem CE-Eingang die ihm über seinen C-Eingang zugeführten Clock-Impulse. Bei jedem Überlauf des Zählers 7 gibt er einen Impuls über seinen $C_{out}$-Ausgang an den C-Eingang des Zählers 8 ab und beginnt von vorne zu zählen. Der Zähler 8 seinerzeit zählt die vom Zähler 7 erhaltenen Impulse, gibt bei Überlauf einen Impuls über seinen $C_{out}$-Ausgang an den C-Eingang des Zählers 9 ab und beginnt von vorne zu zählen. Alle drei Zähler 7, 8, 9 sind durch einen Impuls an ihren Rücksetzeingang R gleichzeitig rücksetzbar.

Der Inhalt des ersten Zählers 7 gibt die EINER-Stelle, der Inhalt des zweiten Zählers 8 die ZEHNER-Stelle und der Inhalt des dritten Zählers 9 die HUNDERTER-Stelle der 100-Segmente-Anzeige an. Die Zählerinhalte der Zähler 7, 8, 9 werden einem Speicher 10 zum Festhalten des Anzeigewertes für eine Anzeigeperiode zugeführt, bevor die Zähler auf Null rückgesetzt werden. An den Speicher 10 ist ausgangsseitig eine Ansteuerlogik 11 angeschlossen.

Die Ansteuerlogik 11 wählt entsprechend dem ihr zugeführten

0073452

Eingangssignal (= Meßwertsignal oder Grenzwertsignal) die anzusteuernden Leitungen für die Flüssigkristall-Bargraph-Anzeige aus. Zu diesem Zweck wird ihr auch ein Mode-Signal M zugeführt, wobei z.B. ein positives Mode-Signal ($V_{DD}$) bedeutet, daß das Eingangssignal als Meßwert, d.h. als Balken darzustellen ist und ein Mode-Signal "Null" bedeutet, daß das Eingangssignal als Grenzwert, d.h. als Marke darzustellen ist. Je nach Darstellungsart sind verschiedene Leitungen zur Bargraph-Anzeige anzusteuern. Mit einem Baustein ist jedoch nur eine Bargraph-Anzeige zu bedienen, die entweder im Meßwert-Mode (M = $V_{DD}$) oder im Grenzwert-Mode (M = 0) zu betreiben ist.

Der Ansteuerlogik 11 ist eine Ansteuersignaldurchschaltung 12 nachgeschaltet. Die Ansteuersignaldurchschaltung 12 ist über Ansteuerleitungen 13 (FP- und BP-Leitungen, FP = Frontplane, BP = Backplane) für die Steuerspannungen mit der Flüssigkristall-Bargraph-Anzeige 14 verbunden.

Im Ausführungsbeispiel sind 10 FP-Leitungen (FP = Frontplane) $FP_0$, $FP_1$, $FP_2$, $FP_3$, $FP_4$. $FP_5$, $FP_6$, $FP_7$, $FP_8$, $FP_9$ sowie 10 BP-Leitungen (BP = Backplane) $BP_0$, $BP_1$, $BP_2$, $BP_3$, $BP_4$, $BP_5$, $BP_6$, $BP_7$, $BP_8$, $BP_9$ als Ansteuerleitungen 13 für jede 100-Segment-Anzeige notwendig.

Die Flüssigkristall-Bargraph-Anzeige 14 besteht aus einer Bandanzeige zu 100 Segmenten, wobei die Bandanzeige entweder als Analoganzeige 14a für den eingegebenen Meßwert dient oder als Grenzwertanzeige 14b arbeitet und den eingegebenen unteren Grenzwert $GW_1$, den eingegebenen Mittelwert $GW_2$ sowie den eingegebenen oberen Grenzwert $GW_3$ anzeigt.

Einem Ansteuersignal-Erzeuger 15 werden eingangsseitig für die Aufbereitung der Steuerspannungen analoge Spannungen $V_{DD}$, $V_+$, $V_0$, $V_-$ und $V_{SS}$ zugeführt. Zur Erzeugung dieser analogen Spannungen wird eine positive Gleichspannung +U an ein Potentiometer P gelegt, das über einer Serienschaltung von vier Widerständen $R_1$, $R_2$, $R_3$, $R_4$ mit Massepotential verbunden ist (Spannungsteiler). Dem Widerstand $R_2$ ist ein Kondensator $C_2$ parallelgeschaltet. Der Serienschaltung aus den Widerständen $R_1$ und $R_2$ ist ein Kondensator $C_3$ sowie der Serienschaltung aus den Widerständen $R_3$ und $R_4$ ist ein Kondensator $C_4$ parallelgeschaltet. Am Verbindungspunkt zwischen P und $R_1$ wird die Spannung $V_{DD}$, am Verbindungspunkt zwischen $R_1$ und $R_2$ die Spannung $V_+$, am Verbindungspunkt zwischen $R_2$ und $R_3$ die Spannung $V_0$ sowie am Verbindungspunkt zwischen $R_3$ und $R_4$ die Spannung $V_-$ abgenommen, während $V_{SS}$ gleich dem Massepotential ist. Es sind somit zwei positive Spannungen $V_{DD}$ und $V_+$ sowie zwei negative Spannungen $V_-$ und $V_{SS}$ verfügbar. Die Spannung $V_0$ dient als künstliche Nullpunkt-Spannung für die Ansteuersignale und ist verschieden von der Spannung $V_{SS}$.

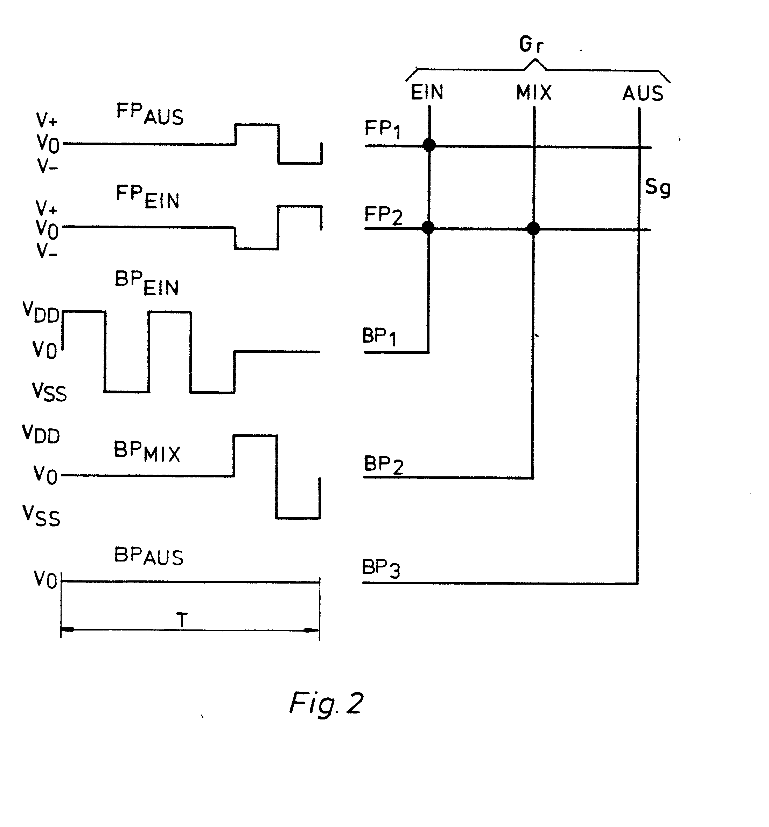

Dem Ansteuersignal-Erzeuger 15 werden ferner die Clock-Impulse als Zeitbasis für die Signalbildung über seinen C-Eingang zugeleitet. Ausgangsseitig gibt der Ansteuersignal-Erzeuger 15 sämtliche Ansteuersignale (siehe hierzu Fig. 2) an die Ansteuersignaldurchschaltung 12 ab. Mittels der Ansteuersignaldurchschaltung 12 wird sichergestellt, daß die richtigen Ansteuerleitungen 13 mit den richtigen Ansteuersignalen beaufschlagt werden.

Ferner liefert der Ansteuersignal-Erzeuger 15 Anfangssignale A für eine neue Anzeigeperiode an den Speicher 10 zum Festhalten des Anzeigewertes für eine Anzeigeperiode, an die Zählersteuerung 6, an die R-Eingänge der Zähler 7, 8, 9, an den S-Eingang des Rückwärtszählers 5 sowie an den C-Eingang

0073452

eines weiteren Zählers (Schieberegisters) 16.

Der Zähler 16 ist ausgangsseitig jeweils mit den ersten Eingängen von drei UND-Gliedern mit negiertem Ausgang 17, 18, 19 verbunden. Die jeweils zweiten Eingänge der UND-Glieder mit negiertem Ausgang 17, 18, 19 werden mit den Mode-Signalen M beaufschlagt. Das Mode-Signal M gelangt ferner zum Steueranschluß des ersten steuerbaren Schalters 3a. Die Ausgangssignale des UND-Gliedes 17 steuern den zweiten Schalter 3b, die Ausgangssignale des UND-Gliedes 18 den dritten Schalter 3c sowie die Ausgangssignale des UND-Gliedes 19 den vierten Schalter 3d an.

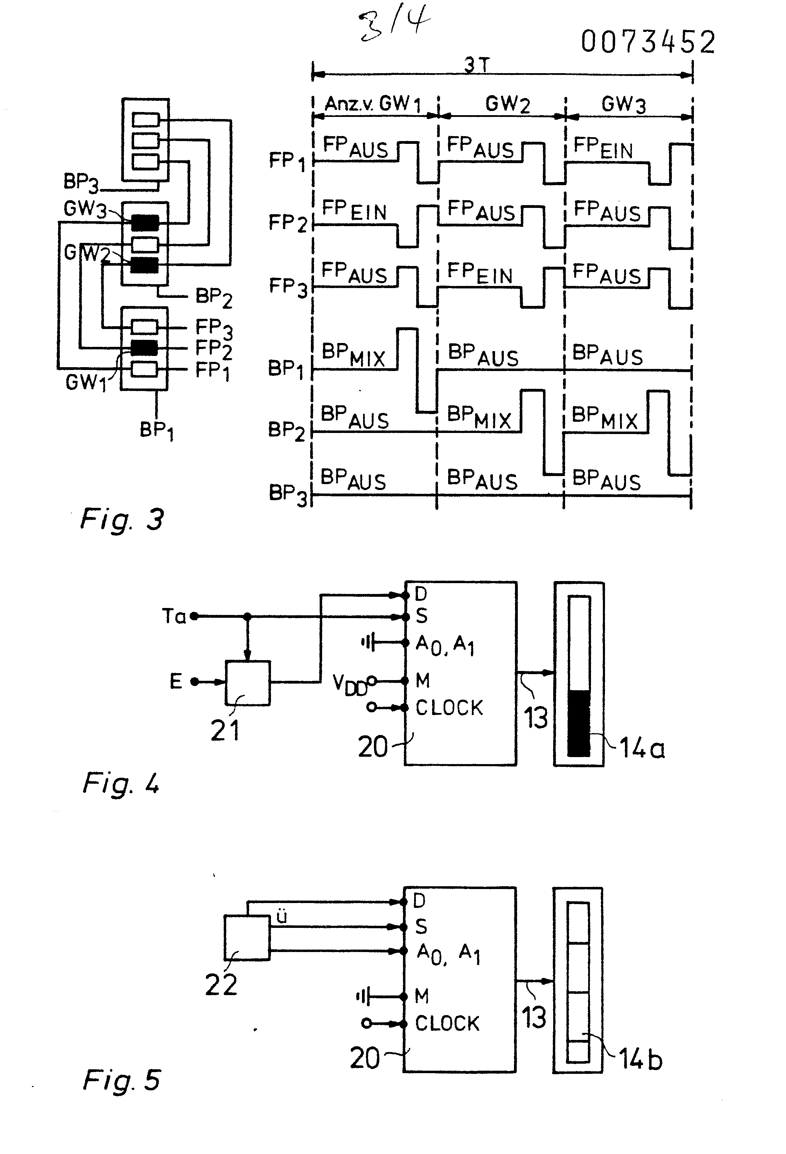

Bei Vorliegen eines positiven Mode-Signales M wird also der erste steuerbare Schalter 3a durchgeschaltet und es kann der im Speicher 1a abgespeicherte Meßwert MW zur Anzeige gebracht werden. Gleichzeitig werden die Schalter 3b, 3c, 3d über die entsprechenden UND-Glieder 17, 18, 19 gesperrt. Bei Vorliegen eines Mode-Signales "Null" wird der Schalter 3a zur Anzeige des Meßwertes gesperrt und die Schalter 3b, 3c, 3d werden nacheinander mit Hilfe des Zählers 16 und der nachgeschalteten UND-Glieder 17, 18, 19 geöffnet. Auf diese Weise können nacheinander während eines Anzeigezyklus 3T (Fig. 3) alle drei Werte $GW_1$, $GW_2$, $GW_3$ zur Anzeige gebracht werden. Durch die Mode-Umschaltung ist dieselbe Flüssigkristall-Bargraph-Anzeige sowohl für die Balkendarstellung als auch für die Darstellung der Grenzmarken verwendbar.

Da der anzuzeigende Wert für die Dauer einer Anzeigeperiode konstant gehalten wird, kann eine häufig eingegebene Meßwertänderung (mehr als 150 neue Meßwerte pro Sekunde) sich nicht negativ auf die Flüssigkristall-Anzeige auswirken. Durch die fest vorgegebene Anzeigeperiode können an der Flüssigkristall-Anzeige keine Gleichspannungsanteile auftreten, welche die Anzeige zerstören würden.

Die Schaltungsanordnung gemäß Fig. 1 mit Ausnahme der Ansteuerleitungen 13 und der Bargraph-Anzeige 14 wird nachfolgend auch als Bargraph-Treiber 20 bezeichnet.

In Fig. 2 sind die Ansteuersignale zur Darstellung von Meßwerten (Balkendarstellung) und Grenzwerten (Markendarstellung) gezeigt. Zur Balkendarstellung werden fünf verschiedene Ansteuersignale $FP_{Aus}$, $FP_{Ein}$ (FP = Frontplane), $BP_{Ein}$, $BP_{Mix}$, $BP_{Aus}$ (BP = Backplane) eingesetzt, wobei $FP_{Aus}$ und $FP_{Ein}$ die Werte $V_+$ (positive Amplitude), $V_0$ (Mittelwert), $V_-$ (negative Amplitude) annehmen, $BP_{Ein}$ und $BP_{Mix}$ die Werte $V_{DD}$ (positive Amplitude), $V_0$ (Mittelwert), $V_{SS}$ (negative Amplitude) annehmen sowie $BP_{Aus}$ konstant $V_0$ während einer Anzeigeperiode T ist.

Die zur Balkendarstellung eingesetzten Ansteuersignale sind aus der DE-OS 27 40 858, insbesondere Fig. 3 bekannt, zur Beschreibung wird darauf verwiesen. Mit GR sind die einzelnen Gruppen der Flüssigkristall-Bargraph-Anzeige 14 bezeichnet, wobei drei Gruppen-Typen unterschieden werden können: EIN-Gruppen, MIX-Gruppen, AUS-Gruppen. Beim Ausführungsbeispiel besteht eine Gruppe jeweils aus 10 Segmenten SG; die 100 Segment-Anzeige weist demnach 10 Gruppen zu je 10 Segmenten auf. Bei den EIN-Gruppen werden jeweils alle 10 Segmente SG der Gruppen gleichzeitig angesteuert, bei den AUS-Gruppen wird keines der Segmente SG angesteuert und bei der MIX-Gruppe wird nur ein Teil der Segmente SG angesteuert. Mit FP sind die Frontplane-Leitungen (im Ausführungsbeispiel 10 Leitungen) und mit BP die Backplane-Leitungen (im Ausführungsbeispiel ebenfalls 10 Leitungen) bezeichnet.

Bei der Grenzwertanzeige (Markendarstellung) kommen lediglich die Ansteuersignale $FP_{Aus}$, $FP_{Ein}$, $BP_{Mix}$ und $BP_{Aus}$ zur Anwendung, nicht jedoch $BP_{Ein}$. Die Kurvenform der Ansteuersignale ist dabei wie in Fig. 2 dargestellt.

In Fig. 3 ist ein Beispiel für eine Grenzwertdarstellung (Markendarstellung) gezeigt, wobei drei Grenzwerte $GW_1$ (unterer Grenzwert), $GW_2$ (Mittelwert), $GW_3$ (oberer Grenzwert) zur Anzeige gebracht werden sollen. Im einzelnen sind drei Gruppen mit je drei Segmenten dargestellt. Die erste Gruppe wird durch die $BP_1$-Leitung, die zweite Gruppe durch die $BP_2$-Leitung sowie die dritte Gruppe durch die $BP_3$-Leitung angesteuert. Die einzelnen Segmente jeder Gruppe sind jeweils miteinander verbunden und an die $FP_1$- bzw. $FP_2$-, bzw. $FP_3$-Leitung angeschlossen.

Während einer Anzeigeperiode T wird jeweils einer der drei Grenzwerte $GW_1$, $GW_2$, $GW_3$ zur Anzeige gebracht. Während eines aus drei Anzeigeperioden T bestehenden Anzeigezyklus 3T kommt jeder der drei Grenzwerte einmal zur Anzeige. Während der ersten Anzeigeperiode T des Zyklus 3T wird der Grenzwert $GW_1$ zur Anzeige gebracht, d.h. das zweite Segment der ersten Gruppe leuchtet auf. Während der zweiten Anzeigeperiode T kommt der Grenzwert $GW_2$ zur Anzeige, d.h. das dritte Segment der zweiten Gruppe leuchtet auf. Während der dritten Anzeigeperiode T des Zyklus 3T wird der Grenzwert $GW_3$ zur Anzeige gebracht, d.h. das erste Segment der zweiten Gruppe leuchtet auf. Die an den einzelnen Ansteuerleitungen $FP_1$, $FP_2$, $FP_3$ bzw. $BP_1$. $BP_2$, $BP_3$ anstehenden Ansteuersignale $FP_{Ein}$, $FP_{Aus}$ bzw. $BP_{Mix}$, $BP_{Aus}$ während jeder Anzeigeperiode T sind in Fig. 3 im einzelnen dargestellt.

Die Multiplexrate hängt vorteilhaft nicht von der Organisation der Flüssigkristall-Anzeige ab, sondern von der Anzahl der anzuzeigenden Grenzwerte. Bei einer Multiplexrate von 3 beträgt die Diskrimination 1,92. Die Anforderungen an die Flüssigkristall-Anzeige kann somit vorteilhaft auf die kleine Multiplexrate entsprechend der Anzahl der anzuzeigenden Grenzwerte ausgelegt werden.

In Fig. 4 ist die Meßwertvorgabe mittels eines Analog/Digital-Wandlers dargestellt. Der analoge Meßwert E wird einem A/D-Wandler 21 zugeleitet. Dem A/D-Wandler 21 liegt eingangsseitig ferner ein Meßtaktsignal $T_a$ an. Ausgangsseitig liefert der A/D-Wandler 21 digitale Meßwerte an den Dateneinang D des Bargraph-Treibers 20. Dem S-Eingang (Strobe) des Bargraph-Treibers 20 werden die Meßtaktsignale $T_a$ ebenfalls zugeleitet, während der Adreßeingang $A_0$, $A_1$ auf Massepotential liegt. Hierdurch wird erzielt, daß die Eingangsdaten im Takt des Strobe-Signales automatisch in den Meßwert-Speicher 1a eingelesen werden. Am M-Eingang (Mode) liegt die positive Versorgungsspannung $V_{DD}$ an, d.h. der Bargraph-Treiber 20 ist konstant auf Meßwertanzeige (Balkendarstellung) geschaltet. Die dem Clock-Eingang zugeführten Taktimpulse weisen eine Frequenz von z.B. 80 kHz auf. Über die 20 Ansteuerleitungen 13 (FP- bzw. BP-Leitungen) ist die Flüssigkristall-Bargraph-Anzeige für Meßwerte 14a an den Bargraph-Treiber 20 angeschlossen.

In Fig. 5 ist die Grenzwertvorgabe mittels einer Tastatur dargestellt. In eine Tastatur 22 werden die Grenzwerte (oberer, unterer Grenzwert, Mittelwert) manuell eingegeben. die Tastatur 22 liefert ausgangsseitig digitale Grenzwertsignale an den Dateneingang D des Bargraph-Treibers 20, ferner Übernahmesignale Ü an dessen S-Eingang und Adreßsignale $A_0$,

$A_1$ an dessen Adreßeingang. Der Mode-Eingang M des Bargraph-Treibers 20 liegt auf Massepotential, d.h. der Bargraph-Treiber 20 ist konstant auf Grenzwertanzeige (Markendarstellung) geschaltet. Ferner werden Clock-Impulse zugeführt. Über die 20 Ansteuerleitungen 13 ist die Flüssigkristall-Bargraph-Anzeige für Grenzwerte 14b an den Bargraph-Treiber 20 angeschlossen.

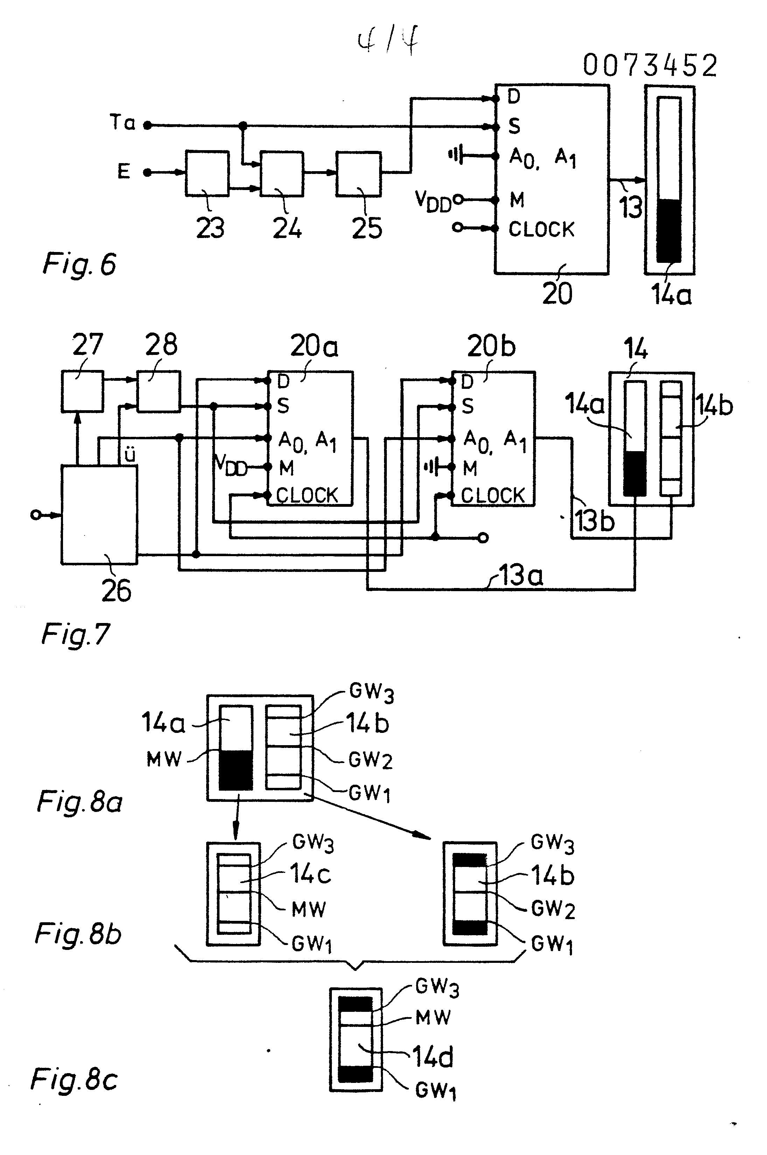

In Fig. 6 ist die Meßwertvorgabe mittels eines Spannungs/Frequenz-Wandlers dargestellt. Der analoge Meßwert E wird über einen U/f-Wandler 23 dem ersten Eingang eines UND-Gliedes 24 zugeführt. Das UND-Glied 24 wird über seinen zweiten Eingang mit Meßtaktsignalen $T_a$ beaufschlagt und ist ausgangsseitig mit einem Zähler 25 (im Ausführungsbeispiel 7-Bit-Zähler) verbunden. Der Zähler 25 liefert digitale Datensignale an den Dateneingang D des Bargraph-Treibers 20. Der S-Eingang des Bargraph-Treibers 20 wird ebenfalls mit Meßtaktsignalen $T_a$ beaufschlagt, während die Adreßeingänge $A_0$, $A_1$ auf Massepotential liegen und der M-Eingang mit der positiven Versorgungsspannung $V_{DD}$ beaufschlagt wird. Dies bedeutet, daß lediglich in den Speicher 1a eingelesen wird und daß lediglich eine Balkendarstellung an der Anzeige 14a vorgesehen ist. Desweiteren werden Clock-Impulse zugeführt. Über 20 Ansteuerleitungen 13 (FP- bzw. BP-Leitungen) ist der Bargraph-Treiber 20 mit der Flüssigkristall-Bargraph-Anzeige 14a zur Meßwertanzeige verbunden.

Durch den Spannungs/Frequenz-Wandler 23 mit nachgeschaltetem Zähler 25 wird eine Digitalisierung des analogen Meßwertes E erzielt, während das UND-Glied 24 eine Synchronisierung zwischen Dateneingabe und Datenübernahme im Treiber 20 bewirkt.

In Fig. 7 ist die gleichzeitige Meßwerteingabe und Grenzwerteingabe mittels eines Mikroprozessors dargestellt. Ein
Mikroprozessor 26 nimmt über seinen Eingang Informationen
über den Meßwert und die Grenzwerte auf. Der Mikroprozessor
26 berechnet diese Informationen und gibt über seinen ersten
Adreßausgang Adreßsignale an einen Adreßdecoder 27 ab. Über
seinen zweiten Adreßausgang liefert der Mikroprozessor 26
direkt Adreßsignale an die Adreßeingänge $A_0$, $A_1$ von zwei
Bargraph-Treibern 20a, 20b. Der Ausgang des Adreßdecodes 27
ist mit dem ersten Eingang eines UND-Gliedes 28 verbunden,
dessen zweiter Eingang durch Übergabesignale Ü des Mikroprozessors 26 beaufschlagt wird. Ausgangsseitig ist das
UND-Glied 28 mit den S-Eingängen der beiden Bargraph-Treiber
20a, 20b verbunden. Der Mikroprozessor 26 gibt die digitalen
Meßwerte bzw. Grenzwerte an die Dateneingänge D der beiden
Bargraph-Treiber 20a, 20b ab. Der M-Eingang des Treibers 20a
wird mit positiver Versorgungsspannung $V_{DD}$ beaufschlagt,
während der M-Eingang des Treibers 20b auf Massepotential
liegt, d.h. der Treiber 20a dient nur zur Meßwertanzeige
(Balkendarstellung) und der Treiber 20b nur zur Grenzwertanzeige (Markendarstellung). Den beiden Treibern 20a, 20b
werden gemeinsame Clock-Impulse zugeleitet. Ausgangsseitig
ist der Treiber 20a über Ansteuerleitungen 13a mit der
Flüssigkristall-Bargraph-Anzeige 14a  für Meßwerte und der
Treiber 20b über Ansteuerleitungen 13b mit der Flüssigkristall-Bargraph-Anzeige 14b für Grenzwerte verbunden.

Die Grenzwerte werden bei diesem Ausführungsbeispiel auf die
gleiche Weise ausgegeben wie die Meßwerte, jedoch die Adressen unterscheiden sich jeweils. Es sind nicht unbedingt zwei
Systeme, bestehend aus Bargraph-Treibern 20a, 20b und Anzeigen 14a, 14b erforderlich. Die Meßwert- und Grenzwert-Darstellungen sind auch mit lediglich einem System möglich, wobei jedoch Mode-Signale M zur Umschaltung von Meßwert- auf Grenzwertanzeige und umgekehrt nötig sind. Diese Mode-Signale M sind dann jeweils vom Mikroprozessor 26 abzugeben. Die beiden letzten Stellen der vom Mikroprozessor 26 ausgegebenen Adresse liegen direkt an den Bargraph-Treibern 20a,20b, während der Adreßdecoder 27 mit nachgeschaltetem UND-Glied 28 nur dann eine Übernahme der Daten erlaubt, wenn die restlichen Stellen der Adresse mit der Adresse der jeweiligen Bargraph-Treiber 20a bzw. 20b übereinstimmt.

In Fig. 8a ist die bisher beschriebene Flüssigkristall-Bargraph-Anzeige 14 mit einer Balkendarstellung 14a des sich ändernden Meßwertes MW und einer Markendarstellung des unteren Grenzwertes $GW_1$, des Mittelwertes (Effektivwertes) $GW_2$ sowie des oberen Grenzwertes $GW_3$ dargestellt. Die Anzeige erfolgt dabei beispielsweise mittels einer 10 x 10 LCD-Matrix mit 100 Segmenten. Sowohl die Organisation wie auch die damit verbundene Anzahl der Segmente sind variabel. Durch Verwendung mehrerer Mode-Signale M kann die Anzeige wie in den Figuren 8b, 8c gezeigt verändert werden.

In Fig. 8b wird in der links gezeigten Flüssigkristall-Bargraph-Anzeige 14c der sich ändernde Meßwert MW nicht mehr als Balken, sondern als Marke dargestellt. Zusätzlich sind in derselben Anzeige 14c der untere Grenzwert $GW_1$ und der obere Grenzwert $GW_3$ als Marken dargestellt. In der rechts gezeigten Flüssigkristall-Bargraph-Anzeige 14b werden der untere Grenzwert $GW_1$ als nach unten geschlossener Balken, der obere Grenzwert $GW_3$ als nach oben geschlossener Balken und der Mittelwert (Effektivwert) $GW_2$ als Marke dargestellt.

In Fig. 8c werden in der Flüssigkristall-Bargraph-Anzeige 14d der untere Grenzwert $GW_1$ als nach unten geschlossener Balken,

der obere Grenzwert $GW_3$ als nach oben geschlossener Balken und der sich ändernde Meßwert MW als Marke dargestellt.

Die Diskrimination beträgt bei der Anzeige 14a gleich 3, bei den Anzeigen 14b,c,d gleich 1,92. Die Anzahl der Marken kann noch erhöht werden, jedoch sinkt ihre Diskrimination mit steigender Zahl ab.

Bei den Anzeigen 14c und 14d ist der Meßwert MW auch noch erkennbar, wenn er sich mit einem der Grenzwerte $GW_1$, $GW_3$ deckt oder bei Anzeige 14d einen der Grenzwerte über- bzw. unterschreitet, da eine Kontrasterhöhung an dem Segment, das dem Meßwert MW entspricht, auftritt. Durch die Doppelbenutzung dieses Segmentes während eines Anzeigezyklus sinkt die Multiplexrate für dieses Segment von 3 auf 3/2 ab und führt somit eine Erhöhung des Kontrastes herbei.

Der Bargraph-Treiber 20 kann auch mit einem internen Multivibrator versehen werden, der extern durch eine RC-Kombination beschaltet wird. Die Taktversorgung mit Clock-Impulsen entfällt somit.

0073452

Mp.-Nr. 622/81                    16

<u>A n s p r ü c h e</u>

1. Anzeigevorrichtung mit reihenförmig angeordneten ansteuerbaren Anzeigeelementen, wobei die Anzeigeelemente einerseits zu Gruppen zusammengefaßt sind sowie andererseits ranggleiche Elemente in den einzelnen Gruppen zusammengeschaltet sind und in kurzzeitigem, für das Auge des Betrachters unerkennbarem Wechsel entweder die EIN-Gruppen, in denen alle Anzeigeelemente zu erregen sind, oder die gemischte Gruppe, in der nur ein Teil der Anzeigeelemente zu erregen ist, angesteuert werden, und wobei eine von Taktimpulsen angesteuerte Zählerkette zur digitalen Aufbereitung der Anzeigewerte vorgesehen ist, der ein Speicher zum Festhalten des Anzeigewertes und eine Ansteuerlogik zur Auswahl der anzusteuernden Ansteuerleitungen zur Flüssigkristall-Bargraph-Anzeige nachgeschaltet sind, <u>gekennzeichnet</u> durch folgende Merkmale:

- zur Zwischenspeicherung der darzustellenden Meßwerte und Grenzwerte als Balken und Marken sind mehrere eingangsseitig parallel angeordnete Speicher (1a,b,c,d) vorgesehen, wobei die Eingangsinformation aus Binärworten besteht und die Datenspeicherung Bit-parallel, jedoch Byte-seriell erfolgt,
- diese Speicher (1a,b,c,d) sind ausgangsseitig über steuerbare Schalter (3a,b,c,d) mit einem gemeinsamen Datenbus (4) verbunden,
- an den Datenbus (4) ist ein voreinstellbarer Rückwärtszähler (5) angeschlossen, der ausgangsseitig mit einer Zählersteuerung (6) verbunden ist, wobei letztere einen ersten Zähler (7) der Zählerkette ansteuert,

0073452

- zur Beaufschlagung der Ansteuerleitungen (13) mit Steuerspannung ist ein mehrere verschiedenartige Ansteuersignale liefernder Ansteuersignal-Erzeuger (15) mit nachgeschalteter Ansteuersignaldurchschaltung (12) vorgesehen.

2. Anzeigevorrichtung nach Anspruch 1, dadurch gekennzeichnet, daß für die sukzessive, Byte-serielle Dateneinspeicherung von Meßwerten und Grenzwerten ein die Speicher (1a,b,c,d) ansteuernder Adreßdecoder (2) vorgesehen ist, wobei die Binärworte jeweils mit Adreßinformationen versehen sind.

3. Anzeigevorrichtung nach Anspruch 1 und folgenden, dadurch gekennzeichnet, daß zur sukzessiven Durchschaltung von zwischengespeicherten Grenzwerten auf den Datenbus (4) ein die steuerbaren Schalter (3b,c,d) ansteuernder weiterer Zähler (16) vorgesehen ist.

4. Anzeigevorrichtung nach Anspruch 3, dadurch gekennzeichnet, daß der Ansteuersignal-Erzeuger (15) mit dem Speicher (10) zum Festhalten des Anzeigewertes, mit der Zählersteuerung (6), mit dem Rückwärtszähler (5), mit den Rücksetzeingängen der einzelnen Zähler (7,8,9) der Zählerkette sowie mit dem weiteren Zähler (16) zur Anzeigeperioden-Taktung verbunden ist.

5. Anzeigevorrichtung nach Anspruch 3, dadurch gekennzeichnet, daß zur Umschaltung zwischen Meßwertdarstellung und Grenzwertdarstellung Mode-Signale zur Ansteuerlogik (11) und zu den steuerbaren Schaltern (3a,b,c,d) zuführbar sind.

6. Anzeigevorrichtung nach Anspruch 5, dadurch gekenn-

0073452

zeichnet, daß den zur Durchschaltung von gespeicherten Grenzwerten dienenden steuerbaren Schaltern (3b,c,d) UND-Glieder mit negiertem Ausgang (17,18,19) zugeordnet sind, denen eingangsseitig die Mode-Signal und die Signale des weiteren Zählers (16) anliegen.

7. Anzeigevorrichtung nach Anspruch 1 und folgenden, dadurch gekennzeichnet, daß dem Ansteuersignal-Erzeuger (15) zwei verschieden große positive Spannungen, zwei verschieden große negative Spannungen sowie eine künstliche Nullpunktspannung zuführbar sind, wobei diese Spannungen mit Hilfe eines Spannungsteilers mit parallelgeschalteten Kondensatoren erzeugbar sind.

*Fig. 1*

Fig. 2

Fig. 3

Fig. 4

Fig. 5

4/4

0073452

Fig.6

Fig.7

Fig.8a

Fig.8b

Fig.8c

Europäisches
Patentamt

**EUROPÄISCHER RECHERCHENBERICHT**

0073452
Nummer der Anmeldung

EP 82 10 7738

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| | --- | | G 01 R 13/40 |
| A | US-A-4 286 265 (S.L. KAUFFMAN) * Spalte 4, Zeilen 33-58; Abbildung 3 * | 1 | |
| | --- | | |
| A | FEINWERKTECHNIK & MESSTECHNIK, Jahrgang 86, Nr. 7, Oktober 1978, Seiten 314-320, Applikationsbericht der ISE Electronics Corp. "Fluoreszenz-Analoganzeige-Bausteine" * Seiten 314-315; Abbildung 4 * | 1 | |
| | --- | | |
| A | ELECTRONIQUE INDUSTRIELLE, Nr. 7, 1. Dezember 1980, Seiten 41-43, Paris, FR. N. FESTE: "Commandes multiplexées d'afficheurs à cristaux liquides" * Seite 43, mittlere Spalte unten; Abbildung 8 * | 1 | |
| | --- | | RECHERCHIERTE SACHGEBIETE (Int. Cl. ³) |
| A | SOCIETY FOR INFORMATION DISPLAY, SID 77, symp April 1977, Seiten 58-59, Los Angeles, USA A.R. KMETZ: "A twisted nematic dual bargraph system" * Seiten 58,59 * | 1 | G 01 R 13/40 G 02 F 1/133 G 01 D 13/24 G 01 D 13/28 |
| | --- | | |
| A,D | DE-A-2 408 062 (DEUTA-WERKE) | | |
| | ----- | | |

Der vorliegende Recherchenbericht wurde für alle Patentansprüche erstellt.

| Recherchenort DEN HAAG | Abschlußdatum der Recherche 09-12-1982 | Prüfer KUSCHBERT D.E. |
|---|---|---|